## Europäisches Patentamt
## European Patent Office
## Office européen des brevets

(11) Publication number: **0 091 815**
**B1**

(12) **EUROPEAN PATENT SPECIFICATION**

(45) Date of publication of patent specification: **11.01.89**

(51) Int. Cl.⁴: **G 11 C 11/40, G 11 C 5/00**

(21) Application number: **83302037.3**

(22) Date of filing: **12.04.83**

(54) **Static-type semiconductor memory device.**

(30) Priority: **12.04.82 JP 59763/82**

(43) Date of publication of application:
**19.10.83 Bulletin 83/42**

(45) Publication of the grant of the patent:
**11.01.89 Bulletin 89/02**

(84) Designated Contracting States:
**DE FR GB**

(56) References cited:
**EP-A-0 028 916**
**US-A-4 198 698**
**IBM TECHNICAL DISCLOSURE BULLETIN, vol. 13, no. 3, August 1970, pages 618-619, New York, US; R.F. SECHLER: "Memory cell"**
**IEEE INTERNATIONAL SOLID-STATE CIRCUITS CONFERENCE, 16th February 1977, pages 78-79, IEEE, Pennsylvania, US; H. MUKAI et al.: "Session VII: High speed memory. Ultra high speed 1K-Bit RAM with 7.5 ns access time"**

(73) Proprietor: **FUJITSU LIMITED**
**1015, Kamikodanaka Nakahara-ku Kawasaki-shi Kanagawa 211 (JP)**

(72) Inventor: **Kimoto, Masayoshi**
**38-6, Chitoseshinmachi Takatsu-ku Kawasaki-shi Kanagawa 213 (JP)**

(74) Representative: **Fane, Christopher Robin King et al**
**HASELTINE LAKE & CO. Hazlitt House 28 Southampton Buildings Chancery Lane London, WC2A 1AT (GB)**

(56) References cited:
**THE SEMICONDUCTOR MEMORY BOOK, Intel Marketing Communications, 1978, NEW YORK, US., COE: "Designing with 16k Dynamic RAMS", pages 130-138**

Courier Press, Leamington Spa, England.

## Description

The present invention relates to a static-type semiconductor memory device.

Generally, a static-type semiconductor memory device comprises a memory cell array consisting of a plurality of memory cells, a peripheral or auxiliary circuit for this memory cell array, and a holding-current supplying circuit. Each static-type memory cell comprises cross-coupled transistors which constitute a flip-flop. The data storing capacity of this memory cell is expressed by $\frac{1}{2}CV$, where C is the amount of the stored charges, and V is the base-base voltage when the above-mentioned transistors are bipolar transistors, or the gate-gate voltage when the above-mentioned transistors are metal-insulator semiconductor (MIS) transistors. The data stored in each memory cell can theoretically be held by continuously supplying a holding current to each memory cell.

However, it is known that, when a semiconductor memory device is contained in a package, the data stored in the semiconductor memory device can be destroyed by alpha particles radiated from the package. The stored data may also be destroyed due to power supply noise, i.e., fluctuations of the power supply voltage. Therefore, countermeasures for alpha particles and power supply noise are desirable.

To obtain a semiconductor memory device resistant to alpha particles and power supply noise, it may be considered to increase the data storing capacity of each memory cell by increasing the above-mentioned C and V. Increase of the C and V of all the memory cells, however, would reduce the switching speed, resulting in undesirably slower writing speed or reading speed. It may also be considered to increase the data storing capacity by increasing the holding current. Conventionally, however, the same holding currents are supplied to both unselected-state memory IC's and selected-state memory IC's. Therefore, the unselected-state memory cells and the selected-state memory cells have the same C and V. If the holding currents are increased in the conventional device, C and V for all memory cells are also increased, resulting in reduced writing or reading speed.

IBM Technical Disclosure Bulletin Vol. 13, No. 3 August 1970 describes a static cell memory in which cell current is decreased in selected-state memory cells only, so as to increase cell noise tolerance in the unselected-stated without saturating the memory cell. The reduced current in the selected-state memory cell shortens the write timing cycle.

When this device is in the unselected-state the increased holding current, combined with load current supplied to auxiliary circuitry including memory cell read circuitry, places extra demands on a power supply used for the device.

It is an object of the invention to provide a static cell memory device in which the demands on its power supply in the unselected-state are tolerable despite the increase in holding current.

According to the present invention there is provided a static-type semiconductor memory device including an array of static memory cells, holding-current supply circuitry for supplying holding current to the memory cells, auxiliary circuitry including memory cell read circuitry, and control means responsive to a memory-selection signal to control the holding current, supplied by the holding-current supply circuitry, so that in the presence of the memory-selection signal the holding current is held at a first value and in the absence of the memory-selection signal the holding current is held at a second value greater than its first value, characterised in that the device includes a plurality of memory blocks, each comprising such an array of static memory cells, with such holding-current supply circuitry, and with such auxiliary circuitry and such control means, the respective control means being responsive to memory-selection signals applied individually to the respective blocks, and in that the said control means of each block further controls the load-current supplied to the auxiliary circuitry of the block concerned and is such that in the presence of the memory-selection signal the load current in that block is held at a first value and in the absence of the memory-selection signal the load current is held at a second value lower than its first value, wherein the said first values and said second values are such that the power drawn by the device when the respective memory selection signals are absent from one or more of the said blocks is no greater than the power drawn by the device when the respective memory-selection signals are present at all of the blocks.

Hence, despite the increase in holding current there is no extra demand on the power supply by virtue of the reduced load current.

It is noted that US—A—4,198,698 describes a memory device in which the load current is turned off in the unselected-state. This document does not however address or solve the object of the invention in terms of the interrelationship between holding current and load current.

One embodiment of the present invention can comprise a static-type semiconductor memory device comprising a plurality of memory blocks arranged in a row direction and in a column direction to form a matrix. Any one row of the memory blocks is operatively selected to carry out a reading or writing operation in the selected memory blocks. Each of the memory blocks comprises a memory cell array, consisting of memory cells, and a peripheral circuit, associated with the memory cell array. The peripheral circuit comprises a holding-current supplying circuit for supplying to the memory blocks a current for holding data stored in the memory cells, and auxiliary circuitry comprising a first current-source circuit for supplying currents through bit lines to the memory cells, a sense amplifier circuit for detecting potential differences between the bit lines, and a second current-source circuit for supplying currents to the sense amplifier circuit.

Each of the memory blocks further comprises a holding-current controlling circuit for controlling the holding-current supplying circuit such that the holding current supplied to an unselected-state memory block is greater than the holding current supplied to a selected-state memory block and that the current supplied to the first current-source circuit, the sense amplifier, and the second current-source circuit, associated with an unselected-state memory block is smaller than the current supplied to the first current-source circuit, the sense amplifier, and the second current-source circuit, associated with a selected-state memory block.

In one preferred embodiment of the invention, the holding-current controlling circuit comprises a differential amplifier for determining whether the memory block is selected or not. The differential amplifier operatively outputs a holding-current determining signal. The holding-current determining signal has a first potential when the memory block is selected and has a second potential when the memory block is unselected. The holding-current determining signals are operatively applied to the holding-current supplying circuit so as to activate the holding-current supplying circuit in response to only the first potential.

Advantageously in such an embodiment, the differential amplifier operatively outputs a current-source current determining signal having the first potential or the second potential when the holding-current determining signal has the second potential or the first potential, respectively. The current-source current determining signal is applied to the first current source and the second current source so as to activate the current sources in response to the potential of the current-source current determining signal.

Preferably in such an embodiment of the invention, each of the memory cells is connected between a word line and a hold line. The word line and the hold line are extended in the row direction. The holding current is conducted from the word line through the memory cell to the hold line. Each of the memory cells is connected between a pair of bit lines extending in the column direction. The holding-current supplying circuit comprises a plurality of first NPN transistors each having a base adapted to receive the holding-current determining signal from the differential amplifier, a collector connected to the hold line, and an emitter connected to a first power supply.

In a further such embodiment of the invention, the first current source and the second current source comprise second NPN transistors each having a base adapted to receive the current-source current determining signal.

In yet another such embodiment of the invention, the differential amplifier comprises: a third NPN transistor, having a base adapted to receive a reference signal, a collector connected through a resistor to a second power supply, and an emitter connected to current source; and a fourth NPN transistor, having a base adapted to receive a block selecting signal, a collector connected through a resistor to the second power supply, and an emitter connected to the current source. The collector of the third NPN transistor is adapted to provide the holding-current determining signal. The collector of the fourth NPN transistor is adapted to provide the current-source current determining signal.

Each of the memory blocks may comprise one memory chip. Alternatively, a predetermined number of the memory blocks may constitute one memory chip.

Reference will now be made, by way of example, to the accompanying drawings, wherein:

Figure 1 is a general block diagram of a semiconductor memory device according to an embodiment of the present invention;

Fig. 2 is a circuit diagram of one of the memory IC chips in the block diagram of Fig. 1, the memory IC chip including a memory cell array, its peripheral circuit, and a holding-current controlling circuit; and

Fig. 3 is an equivalent circuit diagram illustrating an example of a well-known bipolar memory cell.

An embodiment of the present invention will now be described with reference to the drawings.

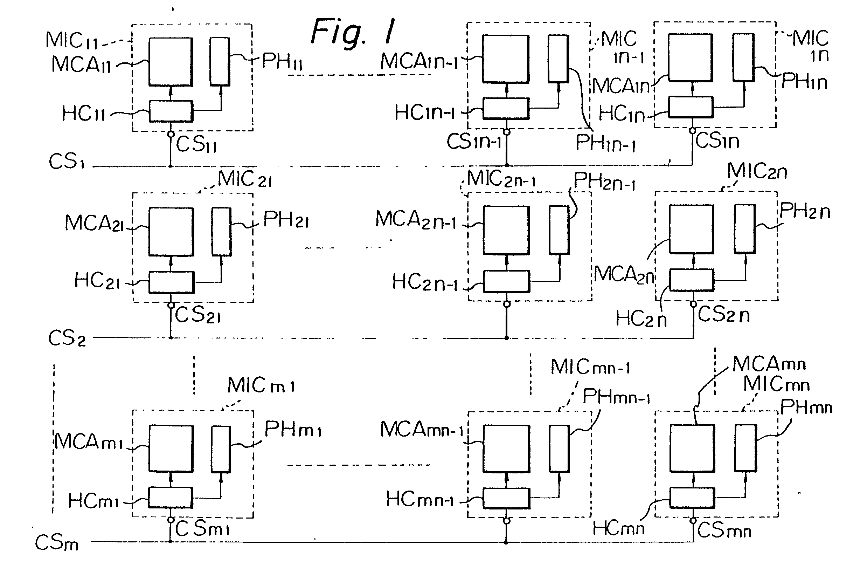

Figure 1 is a general block diagram of an embodiment of the present invention. In the figure, $MIC_{11}$ through $MIC_{mn}$ are memory IC chips; $MCA_{11}$ through $MCA_{mn}$ are memory cell arrays; $PH_{11}$ through $PH_{mn}$ are auxiliary or peripheral circuits of the memory cell arrays; $HC_{11}$ through $HC_{mn}$ are holding-current controlling circuits; $CS_{11}$ through $CS_{mn}$ are chip-selecting terminals; and $CS_1$ through $CS_m$ are chip-selecting signals. Each static-type semiconductor memory IC chip comprises a memory cell array, a peripheral circuit, and a holding-current controlling circuit for controlling the holding current supplied to the memory cell array and the load current supplied to the peripheral circuit. That is, when a memory IC chip is in a selected state, i.e., when the chip-selecting signal applied to the chip-selecting terminal is at a low level, the ratio between the holding current supplied to the memory cells in this chip and the current supplied to the peripheral circuit in this chip is the same as the ratio in conventional devices. When the memory IC chip is in an unselected state, i.e., when the chip-selecting signal is at a high level, the holding current supplied to the memory cells in this chip is increased, and the current supplied to the peripheral circuit in this chip is decreased. The total power consumption in all of the memory IC chips is thus either constant or decreased. Thus, because of the increased holding currents, almost no data stored in the unselected-state memory cells are destroyed.

The operation of the circuit of Fig. 1 will now be described. When the chip-selecting signal $CS_1$ becomes the low level (L) so that the memory IC chips $MIC_{11}$, - - -, and $MIC_{1n}$ in the first row are turned to the selected states, the holding current flowing through the memory cell arrays $MCA_{11}$, - - -, and $MCA_{1n}$ and the current flowing through the peripheral circuits in the first row are the same as the holding current in conventional devices. However, the holding current flowing through the memory cell arrays $MCA_{21}$, - - -, $MCA_{2n}$, - - -, $MCA_{mn}$ in and after the unselected-state second row becomes greater than the holding current in the selected state. Also, the current flowing through the peripheral circuits $PH_{21}$, - - -, $PH_{2n}$, - - -, and $PH_{mn}$ in and after the second row becomes smaller than the current flowing through the selected-state peripheral circuits, as described in detail later. Since no writing or reading operation is carried out in the unselected-state memory IC chips, the operating speed is not reduced even when· the holding current supplied to the unselected memory IC chips is increased. Also, since the peripheral circuit does not operate in the unselected state, the current supplied to the peripheral circuit in the unselected memory IC chip can be decreased without any trouble.

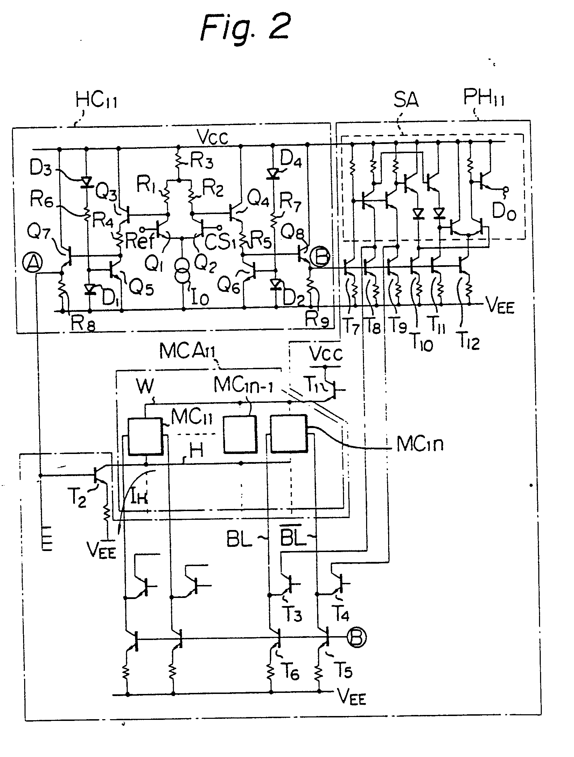

Figure 2 is a circuit diagram of one of the memory IC chips $MIC_{11}$ in the block diagram of Fig. 1. The memory IC chip $MIC_{11}$ includes the memory cell array $MCA_{11}$, its peripheral circuit $PH_{11}$, and the holding-current controlling circuit $HC_{11}$. In Fig. 2, the memory cell array $MCA_{11}$ and the peripheral circuit $PH_{11}$ have well known constructions. In brief, the memory cell array $MCA_{11}$ has bipolar memory cells $MC_{11}$, - - -, $MC_{1n}$, - - - arranged in a matrix. The peripheral circuit $PH_{11}$ includes a word-line driving transistor $T_1$ and a holding-current supplying transistor $T_2$ for each row of the memory cell array, bit-line level detecting transistors $T_3$ and $T_4$, transistors $T_5$ and $T_6$ for supplying currents to the bit lines BL and $\overline{BL}$, and a well-known sense amplifier SA, for each column of the memory cell array. The detected levels of the bit lines BL and $\overline{BL}$ are amplified to obtain the read-out data at an output terminal $D_0$. Transistoirs $T_7$ through $T_{12}$ in the peripheral circuit $PH_{11}$ are transistors for a current source for the sense amplifier. For the sake of simplicity, the other sense amplifiers for the memory cells $MC_{11}$ through $MC_{1n-1}$ and their peripheral circuits are not shown in the drawing.

The holding-current controlling circuit $HC_{11}$ in the illustrated embodiment of the invention, comprises a pair of NPN transistors $Q_1$ and $Q_2$. To the base of the transistor $Q_1$, a reference voltage Ref is operatively applied. To the base of the transistor $Q_2$, a chip-selecting signal $CS_1$ is operatively applied. The emitters of the transistors $Q_1$ and $Q_2$ are commonly connected to a current source $I_0$. The collectors of the transistors $Q_1$ and $Q_2$ are respectively connected via resistors $R_1$ and $R_2$ to one end of the resistor $R_3$, the other end of the resistor $R_3$ being connected to a power supply line $V_{cc}$. The collectors of the transistors $Q_1$ and $Q_2$ are also connected to the bases of NPN transistors $Q_3$ and $Q_4$, respectively. The collectors of the transistors $Q_3$ and $Q_4$ are connected to the power supply line $V_{cc}$. The emitters of the transistors $Q_3$ and $Q_4$ are respectively connected via resistors $R_4$ and $R_5$ to the collectors of NPN, transistors $Q_5$ and $Q_6$. The emitters of the transistors $Q_5$ and $Q_6$ are connected to the ground-power supply line $V_{EE}$. The bases of the transistors $Q_5$ and $Q_6$ are respectively clamped by diodes $D_1$ and $D_2$. That is, the anodes of the diodes $D_1$ and $D_2$ are respectively connected to the bases of the transistors $Q_5$ and $Q_6$, and the cathodes of the diodes $D_1$ and $D_2$ are connected to the ground-power supply line $V_{EE}$. Also, the anodes of the diodes $D_1$ and $D_2$ are respectively connected via resistors $R_6$ and $R_7$ to the cathodes of diodes $D_3$ and $D_4$. The anodes of the diodes $D_3$ and $D_4$ are connected to the power supply line $V_{cc}$. The collectors of the transistors $Q_5$ and $Q_6$ are also connected to the bases of transistors $Q_7$ and $Q_8$, respectively. The collectors of the transistors $Q_7$ and $Q_8$ are connected to the power supply line $V_{cc}$, and the emitters of the transistors $Q_7$ and $Q_8$ are connected via resistors $R_8$ and $R_9$, respectively, to the ground-power supply line $V_{EE}$. The emitter (A) of the transistor $Q_7$ is also connected to the base of the holding-current supplying transistor $T_2$ in this memory cell array $MCA_{11}$. The emitter (B) of the transistor $Q_8$ is also connected to the bases of the transistors $T_7$ through $T_{12}$ and to the bases of the current-source transistors such as the transistors $T_5$ and $T_6$ for the bit lines.

The operation of the circuit of Fig. 2 will now be explained.

Normally, when the potential of the chip-selecting signal $CS_1$ is ·at the H level, which is higher than the reference voltage Ref, the memory IC chips $MIC_{11}$, - - -, and $MIC_{1n}$ in the first row as shown in Fig. 1 are in the unselected state. In this state, with respect to the memory IC chip $MIC_{11}$, the transistor $Q_1$ is off, and the transistor $Q_2$ is on. Accordingly, the base level of the transistor $Q_3$ is at the H level, and the base level of the transistor $Q_4$ is at the L level. Thus, the collector level of the transistor $Q_5$ or the base level of the transistor $Q_7$ becomes high (H level), and the collector level of the transistor $Q_6$ or the base level of the transistor $Q_8$ becomes low (L level). Thus, the potential at the emitter (A) of the transistor $Q_7$ becomes high (H level), and the potential at the emitter (B) of the transistor $Q_8$ becomes low (L level). Accordingly, to the base of the holding-current supplying transistor $T_2$ in the memory cell array $MCA_{11}$, the H level voltage is applied to turn on the transistor $T_2$ so that a large holding current $I_H$ flows from the word line W through the memory cells $MC_{11}$ through $MC_{1n}$ and through the transistor $T_2$ to the ground-power supply line $V_{EE}$. On the other hand, since the L level potential is applied to the bases of the current source transistors $T_7$ through $T_{12}$ and to the bases of the bit-line current source transistors $T_5$, $T_6$, - - -, these transistors $T_5$ through $T_{12}$ are turned off so that the current flowing through the peripheral circuit $PH_{11}$ is decreased. By setting the holding current for the unselected-state memory cells and the current for their peripheral circuit to the appropriate values so that the increase in the power consumption due to the increase of the holding current is compensated with or decreased by the decrease in the power consumption due to the decreased current flowing through the peripheral circuit, the total power consumption in the memory IC chip MIC$_{11}$ is constant regardless of its selected state or unselected state, or may be decreased in comparison with its selected state.

It is apparent that, when the chip-selecting signal CS$_1$ is lower than the reference voltage Ref, an operation inverse to the above-described operation is carried out. That is, the holding current for the selected-state memory cells is decreased, and the current for their peripheral circuit is increased.

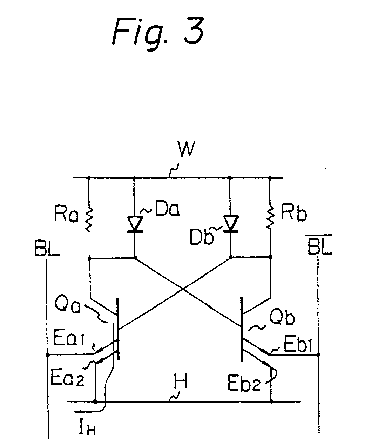

The reason for the increased data-holding capacity of a memory cell due to the increased holding current I$_H$ will now be described with reference to Fig. 3. Figure 3 is an equivalent circuit diagram of an example of a well-known bipolar memory cell. In Fig. 3, the memory cell MC comprises, as is well known, a pair of multi-emitter NPN transistors Q$_a$ and Q$_b$, a load resistor R$_a$ and a clamping diode D$_a$ connected in parallel between the collector of the transistor Q$_a$ and the word line W$_+$, and a load resistor R$_b$ and a clamping diode D$_b$ connected in parallel between the collector of the transistor Q$_b$ and the word line W$_+$. The first emitters E$_{a1}$ and E$_{b1}$ of the transistors Q$_a$ and Q$_b$ are connected to the bit lines BL and $\overline{BL}$, respectively. These emitters E$_{a1}$ and E$_{b1}$ are referred to as detecting emitters. The second emitters E$_{a2}$ and E$_{b2}$ are connected to a hold line H. These emitters E$_{a2}$ and E$_{b2}$ are referred to as holding emitters. So long as the voltage between both ends of the resistor R$_a$ or R$_b$ is smaller than the clamping voltage of the diode D$_a$ or D$_b$, a current flows through the resistor R$_a$ or R$_b$. When the transistor Q$_a$ is in an on state, and the transistor Q$_b$ is in an off state, a current nearly equal to the holding current I$_H$ flows through the resistor R$_a$, while almost no current flows through the resistor R$_b$. Therefore, the base potential of the transistor Q$_a$ is nearly equal to the potential V$_W$ of the word line W, and the base potential of the transistor Q$_b$ is V$_W$−I$_H$·R (where R is the resistance of the resistor R$_a$). Accordingly, the potential difference V between the bases of the transistors Q$_a$ and Q$_b$ can be expressed as follows:

$$V = V_W - (V_W - I_H \cdot R) = I_H \cdot R.$$

The greater the holding current I$_H$, the greater the potential difference V between the bases. Since the data holding capacity can be expressed by $\frac{1}{2}CV$, as described before, the data holding capacity of each memory cell in the unselected memory IC chips is increased by increasing the holding current I$_H$.

It should be noted that a PNPN-type memory cell is also known. In place of the load resistors, the PNPN-type memory cell uses diodes as the loads. Each of these diodes is formed between the emitter and the base of a PNP transistor. In this PNPN-type memory cell, the voltage drop between the ends of the load is not increased even when the holding current is increased. Accordingly, the potential difference between the bases of the transistors which constitute the flip-flop is not increased. However, in this case, when the holding current I$_H$ is increased, the depletion layer of the load PNP transistor is narrowed due to the increase in the forward-direction bias current. Therefore, the capacity C is increased, and, thus, the data holding capacity $\frac{1}{2}CV$ is also increased.

The above explanation has been made in reference to examples using bipolar transistors in memory cells. However, it will be apparent to those skilled in the art that the present invention is also applicable to a static-type semiconductor memory device using MIS transistors. Also, the above explanation described the holding current being increased when the memory IC is unselected. Alternatively, the memory cell array in the memory IC may be separated into several blocks, and the holding current in the unselected-block memory cells may be increased and the supplying current to its peripheral circuit may be decreased.

From the foregoing description, it will be apparent that, in an embodiment of the invention, by making the holding current flowing through unselected-state memory IC chips greater than that flowing through selected-state ones, the data holding capacity of the memory cells in unselected-state memory IC chips, the number of which is usually large, can be increased. Accordingly, the danger of destruction of the stored data in memory cells due to alpha rays or power-supply noise fluctuation is reduced.

**Claims**

1. A static-type semiconductor memory device including an array (MCA) of static memory cells (MC), holding-current supply circuitry (T$_2$) for supplying holding current (IH) to the memory cells, auxiliary circuitry (PH) including memory cell read circuitry, and control means (HC) responsive to a memory-selection signal (CS) to control the holding current, supplied by the holding-current supply circuitry, so that in the presence of the memory-selection signal the holding current is held at a first value and in the absence of the memory-selection signal the holding current is held at a second value greater than its first value, characterised in that the device includes a plurality of memory blocks (MIC), each comprising such an array of static memory cells, with such holding-current supply circuitry, and with such auxiliary circuitry and such control means, the respective control means being responsive to memory-selection signals applied individually to the respective blocks, and in that the said control means of each block further controls the load-current supplied to the auxiliary circuitry of the block concerned and is such that in the presence of the memory-selection signal the load current in that block is held at a first value and in the absence of the memory-selection signal the load current is held at a second value lower than its first value, wherein the said first values and said second values are such that the power drawn by the device when the respective memory selection signals are absent from one or more of the said blocks is no greater than the power drawn by the device when the respective memory-selection signals are present at all of the blocks.

2. A device as claimed in claim 1, in which the second value of the load current is non zero.

3. A memory device as claimed in claim 2, in which the auxiliary circuitry for each block comprises a first current source $(T_5, T_6)$ for supplying current over bit lines $(BL, \overline{BL})$ to said memory cells; a sense amplifier (SA) for detecting potential differences between said bit lines; and a second current source $(T_7$ to $T_{12})$ for supplying current to the sense amplifier.

4. A memory device as claimed in any preceding claim, wherein each said control means $(HC_{11})$ comprises a differential amplifier for determining the presence of the memory-selection control signal, said differential amplifier being operative to output a holding-current determining signal having a first potential in the presence of the memory-selection control signal and having a second potential in the absence of the memory-selection control signal, said holding current determining signal being supplied to activate said holding-current supply circuitry only when it has said first potential.

5. A memory device as claimed in claims 3 and 4, wherein said differential amplifier is operative to output a load current determining signal having said first potential when said holding-current determining signal has said second potential and having said second potential when said holding-current determining signal has said first potential, respectively, said load current determining signal being supplied to said first current source and said second current source so as to activate said current sources in response to the potential of said load current determining signal.

6. A memory device as claimed in claim 4 or 5, wherein each memory cell is connected between a word line (W) and a hold line (H) which extend in a row direction, said holding current for each memory cell being conducted from the word line through that memory cell to the hold line; and wherein each memory cell is further connected between bit lines extending in a column direction, the holding-current supply circuitry for each block comprising an NPN transistor $(T_2)$ having a base adapted to receive said holding-current determining signal from said differential amplifier, a collector connected to the hold line, and an emitter connected to a power supply.

7. A memory device as claimed in claim 5, wherein the auxiliary circuitry for each block comprises a plurality of NPN transistors constituting the first and second current sources, each transistor having its base adapted to receive said load current determining signal.

8. A memory device as claimed in claim 4 or any of claims 5 to 7 when appended thereto, wherein said differential amplifier comprises: a first NPN transistor $(Q_1)$, having a base connected to receive a reference signal (Ref), a collector connected via a resistor to a second power supply, and an emitter connected to a current source $(I_0)$; and a second NPN transistor, $(Q_2)$ having a base connected to receive the memory-selection control signal, a collector connected via a resistor to the second power supply, and an emitter connected to said current source $(I_0)$ wherein the collector of the first NPN transistor is arranged to provide said holding-current determining signal, and the collector of the second NPN transistor is adapted to provide said load current determining signal.

9. A memory device as claimed in claim 7, wherein the said memory blocks are provided by respective separate memory chips.

10. A memory device as claimed in claim 7, wherein the plurality of said memory blocks is provided by one single memory chip.

11. A memory device as claimed in any preceding claim, in which the blocks are arranged in respective sets, all the blocks of each set being connected to receive a memory selection signal in common.

12. A memory device as claimed in claim 11, in which the memory blocks are arranged in a matrix defining rows and columns, with said sets being rows.

**Patentansprüche**

1. Statische Halbleiterspeichervorrichtung mit einer Anordnung (MCA) von statischen Speicherzellen (MC), einer Haltestrom-Versorgungsschaltung $(T_2)$, zum Liefern eines Haltestromes (IH) an die Speicherzellen, einer Hilfsschaltung (PH), die eine Speicherzellenleseschaltung umfaßt, und einer Steuereinrichtung (HC), die auf ein Speicherauswahlsignal (CS) anspricht, um den Haltestrom zu steuern, der von der Haltestrom-Versorgungsschaltung geliefert wird, so daß in Gegenwart des Speicherauswahlsignals der Haltestrom auf einem ersten Wert gehalten wird, und bei Abwesenheit des Speicherauswahlsignals der Haltestrom auf einem zweiten Wert gehalten wird, der größer als der erste Wert ist, dadurch gekennzeichnet, daß die Vorrichtung eine Vielzahl von Speicherblöcken (MIC) enthält, die jeweils solch eine Anordnung von statischen Speicherzellen umfassen, mit solch einer Haltestrom-Versorgungsschaltung, und mit solch einer Hilfsschaltung und solch einer Steuereinrichtung, wobei die jeweiligen Steuereinrichtungen auf die Speicherauswahlsignale ansprechen, die einzeln den jeweiligen Blöcken zugeführt werden, und daß die genannte Steuereinrichtung von jedem Block ferner den Laststrom steuert, der der Hilfsschaltung des betreffenden Blockes zugeführt ist, und so daß in Gegenwart des Speicherauswahlsignales der Laststrom in jenem Block auf einem ersten Wert gehalten wird, und daß bei Abwesenheit des Speicherauswahlsignales der Laststrom auf einem zweiten - Wert gehalten wird, der niedriger als der genannte erste Wert ist, wobei der genannte erste Wert und der genannte zweite Wert so sind, daß die Energie, die von der Vorrichtung gezogen wird, wenn die jeweiligen Speicherauswahlsignale an einem oder mehreren der genannten Blöcke abwesend sind, nicht größer als die Energie ist, die von der Vorrichtung gezogen wird, wenn die jeweiligen Speicherauswahlsignale an allen Blöcken gegenwärtig sind.

2. Vorrichtung nach Anspruch 1, bei der der zweite Wert des Laststromes von 0 verschieden ist.

3. Speichervorrichtung nach Anspruch 2, bei der die Hilfsschaltung für jeden Block eine erste Stromquelle ($T_5$, $T_6$) zum Zuführen eines Stromes über Bitleitungen (BL, $\overline{BL}$) zu den genannten Speicherzellen, umfaßt; einen Leseverstärker (SA) zum Detektieren von Potentialdifferenzen zwischen den genannten Bitleitungen; und eine zweite Stromquelle ($T_7$ bis $T_9$) zum Zuführen eines Stromes zu dem Leseverstärker.

4. Speichervorrichtung nach einem der vorhergehenden Ansprüche, bei der jede der genannten Steuereinrichtungen ($HC_{11}$) einen Differenzverstärker zum Bestimmen der Gegenwart des Speicherausfall-Steuersignals umfaßt, welcher Differenzverstärker betreibbar ist, um ein einen Haltestrom bestimmendes · Signal auszugeben, das bei Gegenwart des Speicherauswahl-Steuersignals ein erstes Potential hat und in Abwesenheit des Speicherauswahl-Steuersignals ein zweites Potential hat, wobei das den Haltestrom bestimmende Signal zugeführt wird, um die genannte Haltestrom-Versorgungsschaltung nur dann zu aktivieren, wenn sie das genannte erste Potential hat.

5. Speichervorrichtung nach einem der Ansprüche 3 und 4, bei der der genannte Differenzverstärker betreibbar ist, um ein einen Laststrom bestimmendes Signal auszugeben, das ein erstes Potential hat, wenn das genannte, den Haltestrom bestimmende Signal das genannte zweite Potential hat, bzw. das genannte zweite Potential hat, wenn das genannte, den Haltestrom bestimmende Signal das genannte erste Potential hat, wobei das den Laststrom bestimmende Signal zu der genannten ersten Stromquelle und der genannten zweiten Stromquelle zugeführt wird, um so die genannten Stromquellen in Abhängigkeit von dem Potential des genannten, den Laststrom bestimmenden Signals zu aktivieren.

6. Speichervorrichtung nach Anspruch 4 oder 5, bei der jede Speicherzelle zwischen einer Wortleitung (W) und einer Halteleitung (H) angeschlossen ist, welche sich in einer Reihenrichtung erstreckt, und der genannte Haltestrom für jede Speicherzelle von der Wortleitung durch die Speicherzelle zu der Halteleitung geführt wird; und bei der jede Speicherzelle ferner zwischen Bitleitungen angeschlossen ist, die sich in einer Spaltenrichtung erstrecken, wobei die Haltestrom-Versorgungsschaltung für jeden Block einen NPN-Transistor ($T_2$) umfaßt, der eine Basis hat, die angepaßt ist, um das genannte Haltestrom-Bestimmungssignal von dem genannten Differenzverstärker zu empfangen, eine Kollektor, der mit der Halteleitung verbunden ist, und einen Emitter, der mit einer Energieversorgung verbunden ist.

7. Speichervorrichtung nach Anspruch 5, bei der die Hilfsschaltung für jeden Block eine Vielzahl von NPN-Transistoren umfaßt, die erste und zweite Stromquellen bilden, wobei die Basis von jedem Transistor angepaßt ist, um das genannte Laststrom-Bestimmungssignal zu empfangen.

8. Speichervorrichtung nach Anspruch 4 oder einem der Ansprüche 5 bis 7 in Verbindung damit, bei der der genannte Differenzverstärker umfaßt: einen ersten NPN-Transistor ($Q_1$), der eine Basis hat, die zum Empfang eines Referenzsignals (Ref) verbunden ist, einen Kollektor, der über einen Widerstand mit einer zweiten Energieversorgung verbunden ist, und einen Emitter, der mit einer Stromquelle ($I_0$) verbunden ist; und einen zweiten NPN-Transistor ($Q_2$), der eine Basis hat, die zum Empfang des Speicherauswahl-Steuersignals verbunden ist, einen Kollektor, der über einen Widerstand mit einer zweiten Energieversorgung verbunden ist, und einem Emitter, der mit der genannten Stromquelle ($I_0$) verbunden ist, wobei der Kollektor des ersten NPN-Transistors angeordnet ist, um das gennante Haltestrom-Bestimmungssignal zu liefern, und der Kollektor des zweiten NPN-Transistors angepaßt ist, um das genannte Laststrom-Bestimmungssignal zu liefern.

9. Speichervorrichtung nach Anspruch 7, bei der die genannten Speicherblöcke durch jeweils separate Speicherchips gebildet werden.

10. Speichervorrichtung nach Anspruch 7, bei der die Vielzahl von genannten Speicherblöcken durch einen einzigen Speicherchip gebildet ist.

11. Speichervorrichtung nach einem der vorhergehenden Ansprüche, bei der die genannten Blöcke in jeweiligen Sätzen angeordnet sind, wobei alle die Blöcke von jedem Satz verbunden sind, um gemeinsam ein Speicherauswahlsignal zu empfangen.

12. Speichervorrichtung nach Anpruch 11, bei der die Speicherblöcke, in eine Matrix definierenden, Reihen und Spalten angeordnet sind, wobei die genannten Sätze Reihen sind.

**Revendications**

1. Dispositif de mémoire à semiconducteur du type statique incluant une matrice (MCA) de cellules de mémoire statique (MC), des circuits de fourniture de courant de maintien ($T_2$) pour fournir un courant de maintien (IH) aux cellules de mémoire, des circuits auxiliaires (PH) incluant des circuits de lecture de cellules de mémoire, et des moyens de commande (HC) réagissant à un signal de sélection de mémoire (CS) pour contrôler le courant de maintien, fourni par les circuits de fourniture de courant de maintien, de sorte qu'en présence du signal de sélection de mémoire, le courant de maintien est maintenu à une première valeu et, en l'absence du signal de sélection de mémoire, le courant de maintien est maintenu à une deuxième valeur supérieure à sa première valeur, caractérisé en ce que le dispositif comprend un ensemble de blocs de mémoire (MIC), comprenant chacun une matrice de cellules de mémoire statique, avec les circuits de fourniture de courant de maintien, et avec les circuits auxiliaires et les moyens de commande, les moyens de commande respectifs réagissant aux signaux de sélection de mémoire appliqués individuellement aux blocs respectifs, et en ce que le moyen de commande de chaque bloc contrôle en outre le courant de charge fourni au circuit auxiliaire du bloc concerné et est tel qu'en présence du signal de sélection de mémoire, le courant de charge dans ce bloc est maintenu à une première valeur et, en l'absence du signal de sélection de mémoire, le courant de charge est maintenu à une deuxième valeur inférieure à sa première valeur, où les premières valeurs et les deuxièmes valeurs sont telles que la puissance tirée par le dispositif quand les signaux de sélection de mémoire respectifs sont absents d'un ou plusieurs des blocs n'est pas supérieure à la puissance tirée par le dispositif quand les signaux de sélection de mémoire respectifs sont présents dans tous les blocs.

2. Dispositif selon la revendication 1, dans lequel la deuxième valeur du courant de charge n'est pas égale à zéro.

3. Dispositif de mémoire selon la revendication 2, dans lequel le circuit auxiliaire pour chaque bloc comprend une première source de courant ($T_5$, $T_6$) pour fournir un courant aux cellules de mémoire par des fils de bit (BL, $\overline{BL}$); un amplificateur de détection (SA) pour détecter des différences de potentiel entre les fils de bit; et une deuxième source de courant ($T_7$ à $T_{12}$) pour fournir un courant à l'amplificateur de détection.

4. Dispositif de mémoire selon l'une quelconque des revendications 1 à 3, dans lequel chaque moyen de commande ($HC_{11}$) comprend un amplificateur différentiel pour déterminer la présence du signal de commande de sélection de mémoire, l'amplificateur différentiel étant actif pour engendrer en sortie un signal de détermination de courant de maintien ayant un premier potentiel en présence du signal de commande de sélection de mémoire et ayant un deuxième potentiel en l'absence du signal de commande de sélection de mémoire, le signal de détermination de courant de maintien étant fourni pour rendre actifs les circuits de fourniture de courant de maintien uniquement quand il a le premier potentiel.

5. Dispositif de mémoire selon l'une quelconque des revendications 3 et 4, dans lequel l'amplificateur différentiel est actif pour engendrer en sortie un signal de détermination de courant de charge ayant le premier potentiel quand le signal de détermination de courant de maintien à le deuxième potentiel et ayant le deuxième potentiel quand le signal de détermination de courant de maintien a le premier potentiel, respectivement, le signal de détermination de courant de charge étant fourni à la première source de courant et à la deuxième source de courant de manière à rendre actives les sources de courant en réponse au potentiel du signal de détermination de courant de charge.

6. Dispositif de mémoire selon l'une quelconque des revendications 4 et 5, dans lequel chaque cellule de mémoire est connectée entre un fil de mot (W) et un fil de maintien (H) qui s'étendent dans une direction de ligne, le courant de maintien pour chaque cellule de mémoire étant conduit du fil de mot au fil de maintien par l'intermédiaire de cette cellule de mémoire; et dans lequel chaque cellule de mémoire est connectée en outre entre des fils de bit s'étendant dans une direction de colonne, le circuit de fourniture de courant de maintien pour chaque bloc comprenant un transistor NPN ($T_2$) ayant une base agencée pour recevoir le signal de détermination de courant de maintien de l'amplificateur différentiel, un collecteur connecté au fil de maintien, et un émetteur connecté à une source d'alimentation.

7. Dispositif de mémoire selon la revendication 5, dans lequel le circuit auxiliaire pour chaque bloc comprend un ensemble de transistors NPN constituant les première et deuxième sources de courant, chaque transistor ayant sa base agencée pour recevoir le signal de détermination de courant de charge.

8. Dispositif de mémoire selon l'une quelconque des revendications 4 et 5 à 7 dépendantes de celle-ci, dans lequel l'amplificateur différentiel comprend: un premier transistor NPN ($Q_1$), ayant une base connectée pour recevoir un signal de référence (Ref), un collecteur connecté par une résistance à une deuxième source d'alimentation, et un émetteur connecté à une source de courant ($I_0$); et un deuxième transistor NPN ($Q_2$), ayant une base connectée pour recevoir le signal de commande de sélection de mémoire, un collecteur connecté par une résistance à la deuxième source d'alimentation, et un émetteur connecté à la source de courant ($I_0$), où le collecteur du premier transistor NPN est agencé pour fournir le signal de détermination de courant de maintien, et le collecteur du deuxième transistor NPN est agencé pour fournir le signal de détermination de courant de charge.

9. Dispositif de mémoire selon la revendication 7, dans lequel les blocs de mémoire sont fournis par des puces de mémoire séparées respectives.

10. Dispositif de mémoire selon la revendication 7, dans lequel l'ensemble des blocs de mémoire est fourni par une seule puce de mémoire.

11. Dispositif de mémoire selon l'une quelconque des revendications 1 à 10, dans lequel les blocs sont disposés en groupes respectifs, l'ensemble des blocs de chaque groupe étant connectés pour recevoir un signal de sélection de mémoire en commun.

12. Dispositif de mémoire selon la revendication 11, dans lequel les blocs de mémoire sont disposés en matrice définissant des lignes et des colonnes, lesdits groupes étant en lignes.

Fig. 1

# Fig. 2

## Fig. 3